## Europäisches Patentamt
## European Patent Office
## Office européen des brevets

(11) Publication number: **0 003 073**
**B1**

(12) **EUROPEAN PATENT SPECIFICATION**

(45) Date of publication of patent specification: **06.05.81**

(51) Int. Cl.³: **H 01 J 37/18, B 23 K 15/00**

(21) Application number: **78300793.3**

(22) Date of filing: **12.12.78**

(54) Electron beam welding machine.

(30) Priority: **19.12.77 US 861988**

(43) Date of publication of application:
**25.07.79 Bulletin 79/15**

(45) Publication of the grant of the European patent:
**06.05.81 Bulletin 81/18**

(84) Designated Contracting States:
**BE DE FR GB IT SE**

(56) References cited:
**FR - A - 2 095 951**
**FR - A - 2 172 075**
**US - A - 3 592 995**
**US - A - 4 044 266**
**US - A - 4 093 843**

**INTER ELECTRONIQUE, vol. 25,**
**July-August 1970 no. 7/8,**
**Paris (FR)**

**G. MORESSEE "Le soudage par**
**faisceau d'électrons" pages 11—13.**

(73) Proprietor: **SCIAKY BROS., INC.**
**4915 West 67th Street**
**Chicago Illinois 60638 (US)**

(72) Inventor: **Sciaky, Albert M.**
**11750 85th Avenue**
**Palos Park Illinois 60464 (US)**

(74) Representative: **Hartley, David et al,**
**c/o Withers & Rogers 4 Dyer's Buildings Holborn**
**London, EC1N 2JT (GB)**

Courier Press, Leamington Spa, England.

## Electron beam welding machine

The present invention relates to an electron beam welding machine and in particular to a machine in which a sliding seal permits relative movement of a electron beam gun and a vacuum chamber into which the electron beam generated by the externally mounted electron gun may pass and within which parts to be welded are mounted. One such machine is described in U.S. Patent Specification 3,742,365. In electron beam welding machines for use in high production industry to produce parts at high speeds on a continuous basis, the sliding seal in particular has given rise to a number of problems. These have been mainly, on machines which include a circular table with a number of sealable pockets equally angularly spaced from each other around a circle near the edge of the circular table, and a seal plate, against which the table slides and is movable intermittently so as to bring a different group of pockets to pre-determined positions under the seal plate. A part to be electron beam welded is placed by an operator upon a suitable fixture within the pocket, the table is moved by an automatic indexing mechanism which indexes the table intermittently from the loading position into a first pre-pumping station and then through a second pumped area where the pocket is evacuated to the pressure suitable for welding, to a welding position underneath the electron beam gun. During the welding, small particles of metal fly off from the weld area and when the table is indexed after each welding operation, the sudden flow of air into or out of each pocket drives the small metal particles into the corners and crevices of the tooling and into the pumps, causing excessive wear of the pump parts and necessitating frequent cleaning and maintenance.

According to this invention an electron beam welding machine comprises means for generating, focussing and deflecting a beam of electrons, a worktable having pockets each of which is adapted for supporting therein a workpiece to be welded, a seal plate disposed adjacent the table, and a flexible seal arrangement defining between the plate and worktable a number (N) of sealed spaces arranged one within the other around the axis of the beam, the worktable and the seal plate being movable relative to each other in a stepwise manner to bring each of the pockets in turn into communication with the innermost one of the (N) sealed spaces maintained at a desired welding pressure with the other (N—1) sealed spaces each maintained at a pressure intermediate the welding pressure and atmospheric pressure, in communication with other ones of the said pockets, such that each pocket in the table communicates with each of sealed spaces completely and in turn during relative movement as it progresses towards the innermost space and communicates with the (N—1) spaces again, in reverse order, as the said pocket progresses away for the innermost space, characterised by two additional sealed spaces which border on the outermost of the (N) sealed spaces at the extremities of the path defined by the said relative movement, such that each pocket is brought into communication with one of the additional sealed spaces during progress towards and away from the innermost space respectively before and after communication with the (N—1) sealed spaces. In a preferred embodiment, each of the (N—1) separate sealed spaces is maintained at a progressively lower pressure, the highest pressure being in the outermost spaces. With such a flexible seal arrangement defining additional sealed spaces the problem of metal particles being blown forcibly against the surfaces of the vacuum chamber or into the vacuum pumps, is avoided. Clearly scoring or grooving of the surface of the worktable is also avoided.

Also, with a machine according to the present invention there is a reduction in the time required for pumping down the system to the welding pressure.

An embodiment of the invention will now be described by way of example with reference to the accompanying drawings, of which:

Figure 1 is a perspective view of an electron beam welding machine incorporating a flexible seal arrangement which utilizes a dial feed work transport mechanism for use in high production applications;

Figure 2 is a cross-sectional view of the worktable of the welding machine of Figure 1, illustrating a pocket for carrying a workpiece to be welded;

Figure 3 and 4 are plan views of the worktable and seal plate of a known electron beam welding machine, in two different relative positions;

Figures 5 and 6 illustrate the worktable and seal plate of an electron beam welding machine in accordance with the new present invention, in two different relative positions; and

Figure 7 is a cross-section of a portion of the worktable and the seal plate and its support, in an electron beam welding machine according to this invention.

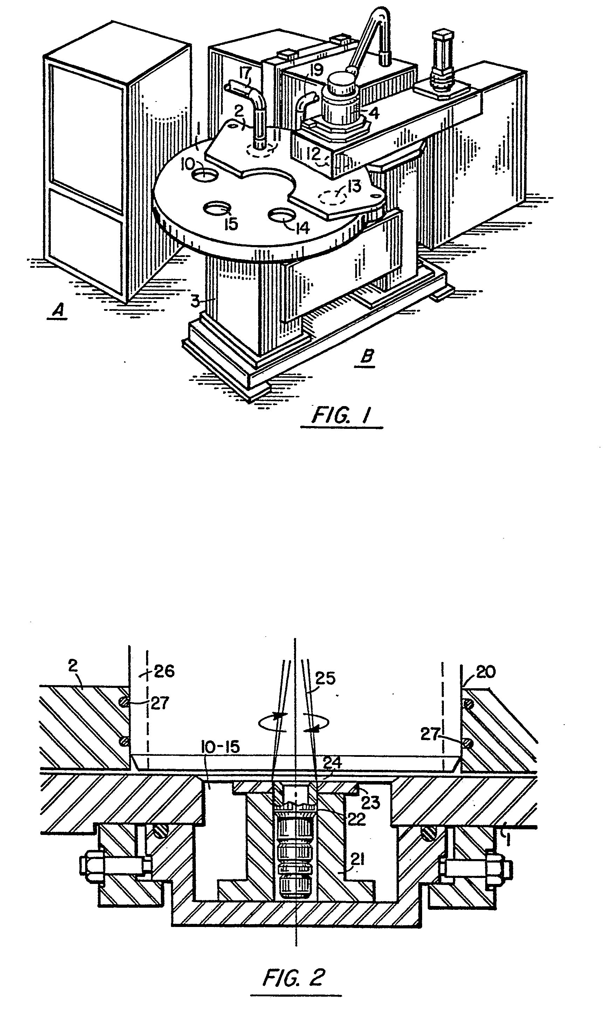

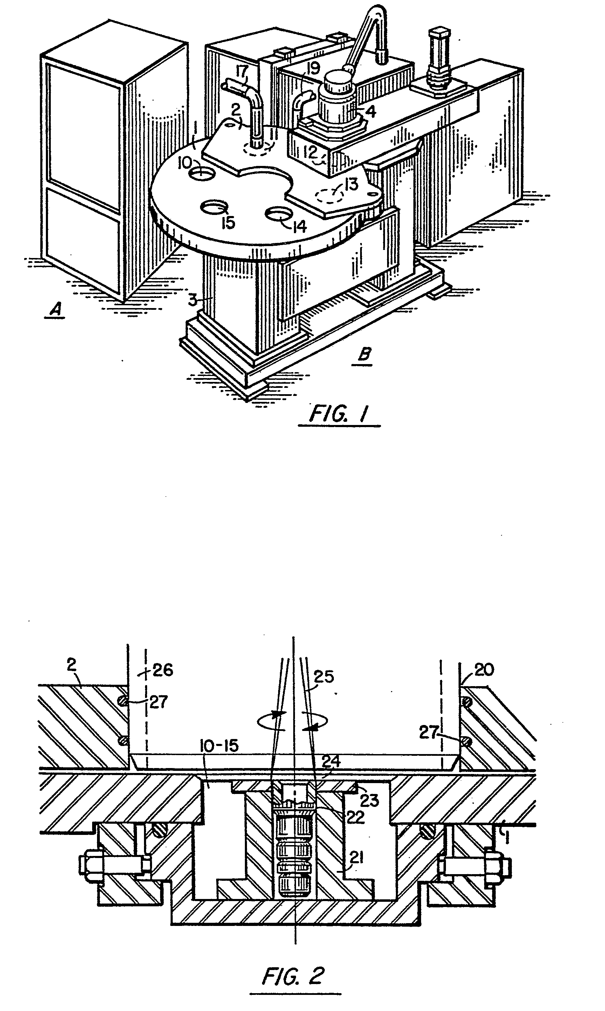

Figure 1 illustrates an electron beam welding machine for use in the highspeed production of parts on a continuous basis. The machine includes a circular worktable 1 with a number of sealable pockets 10 to 15 which are equally angularly spaced around from each other along a circle towards the edge of the worktable and a seal plate 2 against which the table slides so as to bring a different group of pockets to predetermined positions under the seal plate intermittently. Parts to be electron beam welded may be placed upon a suitable fixture within the pocket at position "A" on the table 1 and the table caused to rotate by an automatic indexing mechanism 3 which indexes the table intermittently from the loading position past a sealed off space of small volume between the turntable and the seal plate into a first pre-pumping station and then through a second pump area to a position underneath the electron beam gun 4. The pocket is pumped down to the pressure suitable for welding and the part is then welded during the dwell time of the indexing mechanism. Further indexing then conveys the part to a pre-ejection area which is held at a pressure intermediate the atmospheric and welding pressure and at the next index passes through a sealed off space of low volume to the ejection station "B" where it may be unloaded from the machine.

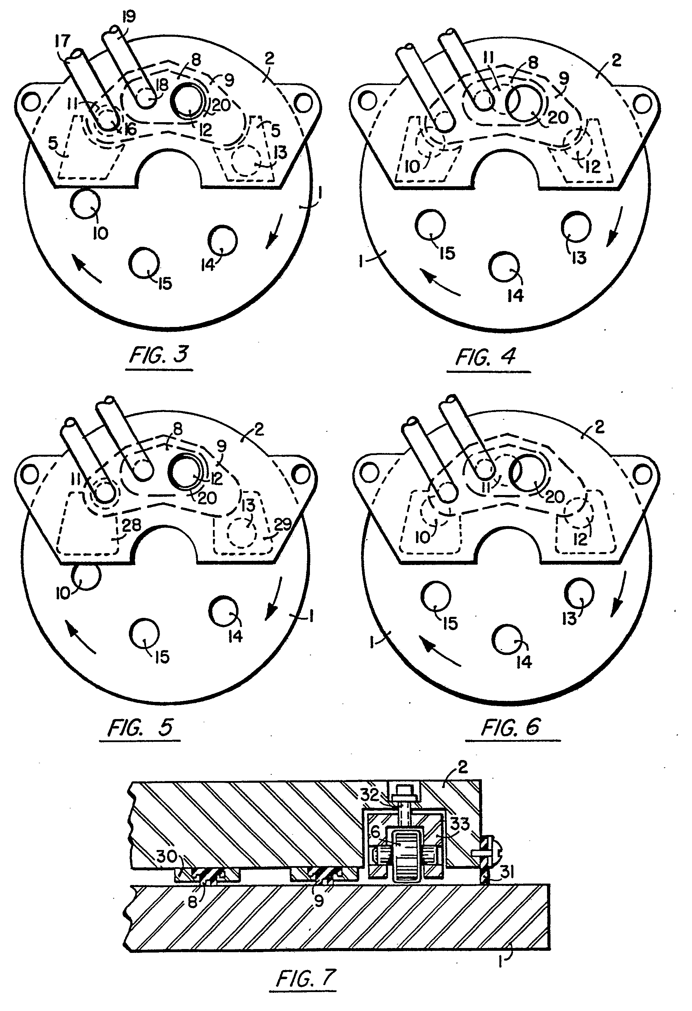

Conventionally, the vacuum seals have been arranged on the seal plate 2 in the configuration shown by the lines broken by dots marked 8 and 9 on figures 3 and 4, so as to define two separate volumes between the table 1 and the seal plate 2, an inner volume enclosed by the inner seal 8 and a second volume between the inner seal 8 and the outer seal 9. The inner seal closes off the area around the pocket containing the part when it is in the welding position under the gun. The second outer seal 9 seals off the volume surrounding the first seal 8. A hole 16 in the plate 2 is connected by piping 17 to a first pumping means which partially evacuates the pocket 11 at the first pumping station. A second pumping means connected through the tubing 19 to a second hole 18 in the seal plate 2 evacuates the space enclosed by the inner seal 8. The electron beam gun housing is installed in a third hole 20 in the seal plate through which the electron beam may pass and is supported and sealed in such a way that the pocket carrying the workpiece or part to be welded, which is directly below the gun, may easily be maintained at a pressure of approximately 6.67 Pa (50 microns).

Figure 2 is a section taken at the welding station of a portion of the worktable 1 showing one of the sealable pockets, 10 to 15, and a fixture 21 used to hold the parts 22 and 23 being welded. In the drawing, the weld is made along the circular path 24 which defines the joint between the parts 22 and 23. The electron beam 25 is controlled to traverse the circular path 24 by any suitable electron beam deflection means associated with the electron gun. The electron gun housing, 26, fits into the hole 20 in the seal plate 2 and is sealed relative to the seal plate by flexible seals 27 so that the space below the gun may be maintained at the desired pressure.

Figures 3 and 4 illustrate the relative position of the seal plate 2 and the table 1 when the table is at rest after indexing. Pocket 12 is shown in the welding position centred beneath the electron beam port 20. While at rest pocket 11 is pre-pumped and pocket 12 is at the welding pressure of approximately 50 microns. When next the table 1 indexes clockwise pocket 10, which is at atmospheric pressure, moves across the seal 9 and, as it crosses the leading edge of seal 9, the area between seal 8 and seal 9 is open to the full atmospheric pressure so that there is a very rapid movement of air into this area and out through pipe 17 as the pump attempts to pump down this area which is open to the atmosphere. This happens also as pocket 12 crosses the opposite edge of seal 9. The in-rush of air, like a compressed air jet, blows anything loose all around the pre-pump region and any metal particles lying loose in this region will be projected violently against all the surfaces into the crevices of the fixture and into the roughing pump. In an attempt to ameliorate this condition, Teflon (Registered Trade Mark) pads 5 were fitted in the space between the worktable and the seal plate in the area immediately ahead and behind the "O" ring seal 9. These pads did not however inhibit the in-rush of air into the pre-pumping area, but did more harm in that any loose metallic particles which were ejected from the evacuated areas became embedded in the teflon pads and caused circumferential grooves to be cut into the surface of the table. These grooves gave rise to leaks from the sealed off low pressure areas to atmosphere so making it difficult to maintain proper vacuum conditions in the two separate sealed off spaces and caused a measurable increase in time required to pump down the system so that production was measurably reduced.

Figures 5 and 6 illustrate a welding machine according to the present invention in which, in addition to the seals 8 and 9 used in conventional machines there are two seals, 28 and 29, mounted upon the seal plate so as to enclose two volumes which are sealed off from the atmosphere and from the first two sealed spaces, one at one end and the other at the other end of the spaces sealed off by seals 8 and 9. These two spaces are not pumped separately. These two dead seal spaces act as described below during indexing from one position to the next. Figure 5 illustrates the "at rest" position of the table, in which welding is performed. After welding, the worktable moves in the clockwise direction, so that as the pocket 12, initially in the welding position, crosses the seal 9, leaves the pre-pumped space and enters the dead seal space, thus connecting the dead seal space to the pre-pumped space between seals 8 and 9. Since, the volume of the dead seal space is small in relation to the volume of the pocket, there is very little movement of air from the dead seal space into the mechanical pump which evacuates the pre-pump space. Because of this, there is no agitation of any particles present in this space. Pocket 10 moves towards the weld area, enters the dead seal space on the left, continues on and at its leading edge, crosses the left edge of seal 9 to connect the pre-pumped space to the dead seal space. Since the volume surrounded by the dead seal is very small, there is no great in-rush of air from the atmosphere into the pre-pumping space and the dead seal space air pressure is reduced to the pressure in the pre-pumping space. There is no in-rush of air to overload the vacuum pump and increase the pressure and the air in pocket 10 is quickly removed by the mechanical pump connected to pipe 17. As each pocket passes across the leading edge of seal 28, the air in the dead seal space is brought to or maintained at atmospheric pressure. As the pocket continues its motion, it becomes completely enclosed by the dead seal space. The pocket then crosses into the pre-pumped area with the volume to be exhausted being only the volume of the pocket plus the small additional volume enclosed by seal 28 and the left end of seal 9. When the pocket leaves the welding area it traverses the right hand edge of seal 9 and connects the small volume surrounded by seal 29 to the pre-pumped area. This small volume of air at atmospheric pressure, however, does not impose a serious strain upon the mechanical pump connected to pipe 17 and creates no turbulence in the sealed space. Small metal particles are not blown forcibly against all surfaces, nor are they blown into the roughing pumps. Also since there are no Teflon pads, there is no risk of abrasion or scoring of the table as described above. Because the air from the atmosphere does not have a free and continuous access to the pre-pumping space during the transition period of the pockets the pump down time for each pocket is greatly reduced and the machine can be operated at higher speeds.

Figure 7 is a cross section of a portion of the worktable and seal plate arrangement, the worktable 1 is maintained at a fixed distance from the seal plate 2 by a number of rollers 6. The endless seals, 8 and 9, are held in place by means of brackets 30 which support all the seals, 8, 9, 28 and 29 along their full length. A wiping seal 31 about the periphery of the edge of the seal plate is fastened to the edge of the seal plate by means of screws. The position of roller support 33 is adjustable by means of a screw 32 so that the force with which the seals bear upon the worktable can be varied.

## Claims

1. An electron beam welding machine comprising means for generating, focussing and deflecting a beam of electrons, a worktable having pockets each of which is adapted for supporting therein a workpiece to be welded, a seal plate disposed adjacent the table, and a flexible seal arrangement defining between the plate and worktable a number (N) of sealed spaces arranged one within the other around the axis of the beam, the worktable and the seal plate being movable relative to each other in a stepwise manner to bring each of the pockets in turn into communication with the innermost one of the (N) sealed spaces maintained at a desired welding pressure with the other (N—1) sealed spaces each maintained at a pressure intermediate the welding pressure and atmospheric pressure, in communication with other ones of the said pockets, such that each pocket in the table communicates with each of sealed spaces completely and in turn during relative movement as it progresses towards the innermost space and communicates with the (N—1) spaces again, in reverse order, as the said pocket progresses away from the innermost space, characterised by two additional sealed spaces which border on the outermost of the (N) sealed spaces at the extremities of the path defined by the said relative movement, such that each pocket is brought into communication with one of the additional sealed spaces during progress towards and away from the innermost space respectively before and after communication with the (N—1) sealed spaces.

2. A machine according to claim 1 wherein each pocket contains a fixture for supporting a workpiece to be welded.

3. A machine according to claim 1 or claim 2 wherein the flexible seal arrangement comprises (N) endless or ring-like flexible seals mounted on the seal plate.

4. A machine according to any one of claims 1 to 3 wherein the flexible seal arrangement comprises at least two endless flexible seals supported on the seal plate and arranged so that each one is positioned wholly within the next one largest to define separate sealed spaces bounded by the innermost of said flexible sealing means the seal plate and the worktable and between each pair of adjacent seals and the seal plate and the worktable, and comprising flexible seals each fastened at each end to the outermost endless flexible seal so as to form the two additional sealed spaces.

5. A machine according to any one of claims 1 to 4 in which each of the (N—1) separate sealed spaces communicates with a separate vacuum pump.

6. A machine according to any one of claims 1 to 5 in which each of the (N—1) separate sealed spaces is maintained at a progressively lower pressure, the highest pressure being in the outermost spaces.

7. A machine according to any one of claims 1 to 5 wherein the number (N) is 2.

8. A machine according to any one of claims 1 to 7 in which the gas pressure in the innermost space is maintained at 6.67 Pa (50 microns).

## Revendications

1. Machine à souder par faisceau d'électrons, comportant des moyens pour engendrer, focaliser et dévier un faisceau d'électrons, une table de travail comportant des cavités dont chacune est prévue pour recevoir une pièce d'oeuvre à souder, une plaque d'étanchéité étant disposée contre la table, et un dispositif d'étanchéité flexible délimitant entre la plaque et la table un nombre (N) d'espaces étanches disposés l'un à l'intérieur de l'autre autour de l'axe du faisceau, la table et la plaque d'étanchéité étant susceptibles de se deplacer l'une par rapport à l'autre pas-à-pas pour amener chacune des cavités à son tour en communication avec le plus interne des (N) espaces étanches maintenus à la pression souhaitée pour la soudure, chacun des (N—1) autres espaces étanches étant maintenus à une pression intermédiaire entre la pression de soudure et la pression atmosphérique, en communication avec une autre des cavités, si bien que chaque cavité sur la table communique avec chacun des espaces étanches complètement et tour à tour pendant le déplacement relatif ou elle progresse vers l'espace le plus interne tandis qu'elle communique de nouveau avec les (N—1) espaces en ordre inverse lorsque cette cavité progresse à partir de l'espace le plus interne, machine caractérisée en ce que elle comporte deux espaces étanches additionels qui encadrent le plus externe des (N) espaces étanches aux extrémités de la course délimitée par ce déplacement relatif, si bien que chaque cavité est amenée en communication avec l'un de ces espaces étanches additionnels pendant la progression vers et à partir de l'espace le plus interne respectivement avant et après la communication avec les (N—1) espaces étanches.

2. Machine selon la revendication 1, caractérisée en ce que chaque cavité contient une fixation pour recevoir une pièce d'oeuvre à souder.

3. Machine selon l'une quelconque des revendications 1 et 2, caractérisée en ce que le dispositif d'étanchéité flexible comporte (N) joints flexibles sans fin ou annulaires montés sur la plaque d'étanchéité.

4. Machine selon l'une quelconque des revendications 1 à 3, caractérisée en ce que le dispositif d'étanchéité flexible comporte au moins deux joints flexibles sans fin montés sur la plaque d'étanchéité et disposés de façon telle que chacun d'eux est placé complètement à l'intérieur du plus grand joint immédiatement voisin de façon à définir des espaces étanches séparés délimités par le plus interne de ces joints flexibles, par la plaque d'étanchéité, et par la table de travail, et situé entre chaque paire de joints adjacents, la plaque d'étanchéité et la table de travail, le dispositif de joints flexibles comportant également des joints flexibles dont chacun est fixé à chaque extrémité aux joints flexibles extérieurs de façon à constituer les deux espaces étanches additionnels.

5. Machine selon l'une quelconque des revendications 1 à 4, caractérisée en ce que chacun des (N—1) espaces étanches distincts communique avec une pompe à vide distincte.

6. Machine selon l'une quelconque des revendications 1 à 5, caractérisée en ce que chacun des (N—1) espaces étanches distincts est maintenu à une pression progressivement plus basse, la pression la plus élevée régnant dans les espaces extérieurs.

7. Machine selon l'une quelconque des revendications 1 à 5 caractérisée en ce que le nombre (N) est 2.

8. Machine selon l'une quelconque des revendications 1 à 7, caractérisée en ce que la pression de gaz dan l'espace interne est maintenue à 6, 67 Pa (50 microns).

**Patentansprüche**

1. Elektronenstrahlschweißmaschine mit einer Einrichtung zur Erzeugung, Fokussierung und Ablenkung eines Elektronenstrahls, einem Arbeitstisch mit Taschen zur Aufnahme eines zu schweißenden Werkstücks, einer am Tisch angeordneten Dichtungsplatte, und einer biegsamen Dichtungsanordnung, die zwischen Platte und Arbeitstisch eine Anzahl (N) von ineinander und um die Strahlachse herum angeordneten abgedichteten Räume bestimmt, wobei Arbeitstisch und Dichtungsplatte die einzelnen Taschen nacheinander mit dem auf dem gewünschten Schweißdruck gehaltenen innersten der (N) abgedichteten Räume bei auf einem zwischen dem Schweißdruck und Atmosphärendruck liegenden Druck gehaltenen und in Verbindung mit anderen der Taschen stehenden anderen (N—1) abgedichteten Räumen in Verbindung bringend schrittweise relativ zueinander beweglich sind derart, daß jede Tasche des Tisches während ihres im Zuge der Relativbewegung erfolgenden Weiterschreitens zum innersten Raum mit jedem der abgedichteten Räume vollständig und aufeinanderfolgend in Verbindung steht und mit den (N—1) Räumen in umgekehrter Reihenfolge erneut in Verbindung steht, wenn sie vom innersten Raum weg weiterschreitet, gekennzeichnet durch zwei zusätzliche abgedichtete Räume, welche an den äußersten der (N) abgedichteten Räume an den Enden des durch die Relativbewegung bestimmten Weges angrenzen derart, daß jede Tasche bei ihrem Weiterschreiten zum und vom innersten Raum vor bzw. nach dem In-Verbindung-Stehen mit den (N—1) abgedichteten Räumen jeweils mit einem der zusätzlichen abgedichteten Räume in Verbindung gebracht wird.

2. Maschine nach Anspruch 1, bei welcher jede Tasche eine Befestigung zur Halterung eines zu schweißenden Werkstücks enthält.

3. Maschine nach Anspruch 1 oder 2, bei welcher die biegsame Dichtungsanordnung (N) auf der Dichtungsplatte angebrachte endlose bzw. ringförmige biegsame Dichtungen umfaßt.

4. Maschine nach einem der Ansprüche 1 bis 3, bei welcher die biegsame Dichtungsanordnung wenigstens zwei endlose biegsame Dichtungen, die auf der Dichtungsplatte sitzen und so angeordnet sind, daß jede vollständig innerhalb der nächstgrößeren liegt, so daß getrennte abgedichtete Räume bestimmt werden, die durch die innerste der biegsamen Dichtungen, die Dichtungsplatte und den Arbeitstisch, und jeweils zwischen Paaren benachbarter Dichtungen, der Dichtungsplatte und dem Arbeitstisch begrenzt sind, sowie biegsame Dichtungen, von denen jede an jedem ihrer Enden an der äußersten endlosen biegsamen Dichtung die zwei zusätzlichen abgedichteten Räume ausbildend befestigt ist, umfaßt.

5. Maschine nach einem der Ansprüche 1 bis 4, bei welcher jeder der (N—1) getrennten abgedichteten Räumen mit einer eigenen Vakuumpumpe in Verbindung steht.

6. Maschine nach einem der Ansprüche 1 bis 5, bei welcher die (N—1) getrennten abgedichteten Räume auf zunehmend niedrigerem Druck gehalten werden, wobei der höchste Druck in den äußersten Räumen herrscht.

7. Maschine nach einem der Ansprüche 1 bis 5, bei welcher die Anzahl (N) gleich 2 ist.

8. Maschine nach einem der Ansprüche 1 bis 7, bei welcher der Druck des Gases im innersten Raum bei 6.67 Pa (50 Mikron) erhalten wird.

0 003 073

*FIG. 1*

*FIG. 2*

1

FIG. 1

FIG. 2

1

FIG. 3

FIG. 4

FIG. 5

FIG. 6

FIG. 7

2